# EUROPÄISCHE PATENTSCHRIFT

(11) **EP 0 976 005 B1**
(45) Veröffentlichungstag und Bekanntmachung des Hinweises auf die Patenterteilung: **17.03.2004**
(21) Anmeldenummer: 98961043.1
(22) Anmeldetag: 26.10.1998
(51) Int. Cl.: G02B 26/08

(54) **HERSTELLUNGSVERFAHREN FÜR MIKROMECHANISCHE VORRICHTUNG**
METHOD FOR PRODUCING A MICROMECHANICAL DEVICE
PROCEDE DE FABRICATION POUR DISPOSITIF MICROMECANIQUE

(30) Priorität: 22.12.1997 DE 19757197
(43) Veröffentlichungstag der Anmeldung: 02.02.2000
(73) Patentinhaber: ROBERT BOSCH GMBH, 70442 Stuttgart (DE)
(72) Erfinder: FUNK, Karsten, D-70195 Stuttgart (DE); FREY, Wilhelm, D-70178 Stuttgart (DE)
(86) Internationale Anmeldenummer: PCT/DE1998/003129
(87) Internationale Veröffentlichungsnummer: WO 1999/032919

(56) Entgegenhaltungen:
- EP-A- 0 664 470
- EP-A- 0 712 022
- US-A- 3 886 310
- US-A- 4 596 992
- BUEHLER J ET AL: "ELECTROSTATIC ALUMINUM MICROMIRRORS USING DOUBLE-PASS METALLIZATION" JOURNAL OF MICROELECTROMECHANICAL SYSTEMS, Bd. 6, Nr. 2, Juni 1997, Seiten 126-134, XP000723784 in der Anmeldung erwähnt
- HORNBECK L J: "DEFORMABLE-MIRROR SPATIAL LIGHT MODULATORS" SPATIAL LIGHT MODULATORS AND APPLICATIONS III, 7-8 AUGUST 1989, SAN DIEGO, Bd. 1150, 7. August 1989, Seiten 86-102, XP000351394 in der Anmeldung erwähnt
- SAMPSELL J B: "DIGITAL MICROMIRROR DEVICE AND ITS APPLICATION TO PROJECTION DISPLAYS" JOURNAL OF VACUUM SCIENCE AND TECHNOLOGY: PART B, Bd. 12, Nr. 6, 1. November 1994, Seiten 3242-3246, XP000497144

## Beschreibung

### STAND DER TECHNIK

Die vorliegende Erfindung betrifft ein Herstellungsverfahren für eine mikromechanische Vorrichtung, insbesondere für einen mikromechanischen Schwingspiegel.

Obwohl auf beliebige mikromechanische Vorrichtungen anwendbar, werden die vorliegende Erfindung sowie die ihr zugrundeliegende Problematik in bezug auf einen mikromechanischen Schwingspiegel erläutert.

Es existieren mehrere Designvarianten für mikromechanische Schwingspiegel. Beispielsweise kann eine Aluminium-Membran durch elektrostatische Kräfte ausgelenkt werden, wie in Texas Instruments, L.J. Hornbeck, Proc. Soc. Photo-Opt. Instrum. Eng. 1150 (1989) 86; J. Bühler et al. J. MEMS 6 (1997) 126 offenbart.

Über bewegliche Spiegel aus monokristallinem Silizium (IBM, K.E. Petersen, IBM J. Res. Develop. 24 (1980) 631) oder aus Polysilizium (CSEM, V.P. Jaecklin et al., Proc. IEEE Micro Electro Mech. System Workshop, FL, USA (1993) 124) wird ebenfalls berichtet.

Die Druckschriften EPO 712022 A und US 3886310 A offenbaren ebenfalls Verfahren zur Herstellung mikromechanischer Schwingspiegel.

Die der vorliegenden Erfindung zugrundeliegende Problematik besteht darin, daß diese Konzepte vor allem bei großen Spiegeln mit Lateraldimensionen im Bereich von einigen 100 µm lediglich kleine Winkelauslenkungen im Bereich von wenigen Grad erlauben, was auf die beschränkte maximal mögliche Randauslenkung zurückzuführen ist. Bei oberflächen-mikromechanischen Konzepten wird die Randauslenkung durch den kleinen Substratabstand von einigen wenigen Mikrometern begrenzt, während bei den bulk-mikromechanischen Komponenten die dicken Torsionsfederaufhängungen auch bei großen Antriebsspannungen nur relativ geringe Torsionswinkel zulassen bzw. Herstellungstoleranzen große Streuungen der Spiegeleigenschaften hervorrufen.

### VORTEILE DER ERFINDUNG

Das erfindungsgemäße Herstellungsverfahren mit den Merkmalen des Anspruchs 1 weist gegenüber den bekannten Lösungsansätzen den Vorteil auf, daß große Auslenkwinkel erreicht werden können, ohne daß die Prozeßtechnologie erschwert ist.

Die der vorliegenden Erfindung zugrundeliegende Idee besteht darin, daß eine mikromechanische Vorrichtung, insbesondere eine resonante Schwingspiegelvorrichtung aus Silizium, an Verbindungsstegen, vorzugsweise langen Balken aus Silizium, derart freibeweglich aufgehängt ist, daß er sich um seine Längsachse drehen kann. Darunter ist das Bulkmaterial vollständig entfernt, d.h. der Wafer lokal durchlöchert, so daß die Vorrichtung um die Verbindungsstege Torsionsschwingungen ausführen kann, die eine solche Amplitude aufweisen, daß ein Teil der Vorrichtung in den Bereich des entfernten Bulkmaterials hineinragt.

Im Fall einer resonanten Schwingspiegelvorrichtung dient die reflektierende Fläche des Spiegels gleichzeitig als Aktor zur Verstellung des Spiegels. Eine zum Beispiel durch justiertes Gegenbonden unter dem Spiegel plazierte Gegenelektrode bildet mit der Spiegelfäche einen Kondensator. Durch Anlegen einer elektrischen Spannung wird das Spiegelelement ausgelenkt. Die Vorrichtung kann bei Umgebungsdruck betrieben werden, da aufgrund des großen Abstandes zwischen Spiegel und gegengebondeten Antriebselektoden nur eine relativ geringe Luftreibung vorhanden ist. Wird das Spiegelelement durch die Aktoren in seiner mechanischen Resonanz angeregt, so wird die durch die elektrostatischen Kräfte erreichbare Auslenkung des Aktors durch den Faktor der mechanischen Güte überhöht.

In den Unteransprüchen finden sich vorteilhafte Weiterbildungen und Verbesserungen des in Anspruch 1 angegebenen Herstellungsverfahrens.

Gemäß einer bevorzugten Weiterbildung erfolgt zunächst das Durchätzen des Bereichs der dritten Schicht, danach das Durchätzen der ersten Schicht und danach das Entfernen des Bereichs der zweiten Schicht.

Gemäß einer weiteren bevorzugten Weiterbildung erfolgt das Durchätzen des Bereichs der dritten Schicht durch eine anisotrope Rückseitenätzung. Mit etablierten Naßätzverfahren, z.B. KOH, TMAH, können kostengünstig tiefe Strukturen in Silizium geätzt werden. Auf die Strukturierung wirkt sich die Notwendigkeit von Kompensationsstrukturen zum Schutz konvexer Ecken aus.

Gemäß einer weiteren bevorzugten Weiterbildung erfolgt das Durchätzen der ersten Schicht durch eine Trockenätzung. Mit Naßätzverfahren können mikromechanische Federaufhängungen prozeßsicher nur mit Lateraldimensionen von > 100 µm realisiert werden. Demgegenüber können in der Oberflächenmikromechanik durch Trockenätzprozesse (Plasmatrenchen) beliebige Strukturen mit Lateraldimensionen von 10 µm und darunter mit großen Aspektverhältnissen senkrecht ins Substrat geätzt werden. Allerdings ist ein Tiefätzen > 100 µm aus Kostengründen nicht effektiv praktikabel.

Das erfindungsgemäße Verfahren zur Herstellung eines Mikrospiegels mit großen Auslenkwinkeln besteht vorzugsweise aus einer Kombination von einerseits lateral hochauflösendem Trockenätzen der Spiegelstruktur und andererseits dem üblichen Tiefätzen der Rückseitenstruktur.

Gemäß einer weiteren bevorzugten Weiterbildung erfolgt zunächst das Durchätzen der ersten Schicht und danach das Entfernen des Bereichs der zweiten Schicht und das Durchätzen des Bereichs der dritten Schicht.

Gemäß einer weiteren bevorzugten Weiterbildung erfolgt das Durchätzen des Bereichs der dritten Schicht durch eine anodische Rückseitenätzung zum Porösmachen des Bereichs der dritten Schicht und anschließendes Entfernen des porös gemachten Bereichs. In diesem Fall ist kein Vorderseitenschutz (Schutzschicht oder Ätzdose) notwendig, sondern nur eine Rückseitenmaske, beispielsweise aus Gold oder oder Chrom/Gold oder SiO₂+Cr+Au etc., notwendig. Bei den großen Elementen ist der Flächenverbrauch bei (100)-Standard-Wafern im Vergleich zu KOH-geätzten Rückseitenkavernen deutlich verkleinert.

Gemäß einer weiteren bevorzugten Weiterbildung wird der Bereich der zweiten Schicht direkt im Anodisierelektrolyt entfernt. Es ist kein zusätzliches Ätzen der mittleren zweiten Schicht, z.B. Opferoxidätzen, notwendig, denn die zweite Schicht, z.B. das Oxid, wird durch den Anodisier-Elektrolyten geätzt. Das Anodisieren ist im übrigen in der Halbleiterfertigung unkritisch, es werden kein KOH und kein NaOH usw. verwendet, sondern CMOS-kompatible Prozeßflüssigleiten, wie z.B. Flußsäure und DI-Wasser.

Gemäß einer weiteren bevorzugten Weiterbildung erfolgt ein Aufbringen von Gegenelektroden auf einem Sockel und Bonden des Sockels auf die dritte Schicht derart, daß die Gegenelektroden im wesentlichen gegenüber dem Inselbereich liegen. Die Gegenelektroden zum kapazitiven Antrieb des Spiegels werden dabei zweckmäßigerweise auf geeignetem isolierenden Material gegengebondet.

Gemäß einer weiteren bevorzugten Weiterbildung wird eine SOI-Struktur mit einer SOI-Schicht, welche unter Zwischensetzen einer Isolationsschicht auf einer Siliziumsubstratschicht vorgesehen ist, als die dreischichtige Struktur bereitgestellt. Dies ist eine übliche Standardstruktur in der Mikromechanik.

Gemäß einer weiteren bevorzugten Weiterbildung werden als Verbindungsstege schmale Bereiche der ersten Schicht verwendet werden, die durch eine geeignete Maskengeometrie durch den Ätzprozeß gebildet werden. Diese können im Fall der Schwingspiegelvorrichtung als Torsionsfedern dienen.

Gemäß einer weiteren bevorzugten Weiterbildung werden als Verbindungsstege schmale Bereiche einer vorzugsweise metallischen Zusatzschicht verwendet. Diese können im Fall der Schwingspiegelvorrichtung als Torsionsfedern dienen. Bei Realisierung anderer Vorrichtungen können die Verbindungsstege auch als Lagerelemente dienen.

### ZEICHNUNGEN

Ausführungsbeispiele der Erfindung sind in den Zeichnungen dargestellt und in der nachfolgenden Beschreibung näher erläutert.

Es zeigen:
- Fig. 1a-1e: eine Querschnittsdarstellung der Prozeßschritte gemäß einer ersten bevorzugten Ausführungsform des erfindungsgemäßen Verfahrens zur Herstellung eines Schwingspiegels;
- Fig. 2a-2e: eine Querschnittsdarstellung der Prozeßschritte gemäß einer zweiten bevorzugten Ausführungsform des erfindungsgemäßen Verfahrens zur Herstellung eines Schwingspiegels; und
- Fig. 3: eine Draufsicht auf den Schwingspiegel im Prozeßstadium von Fig. 1d bzw. Fig. 2d.

### BESCHREIBUNG DER AUSFÜHRUNGSBEISPIELE

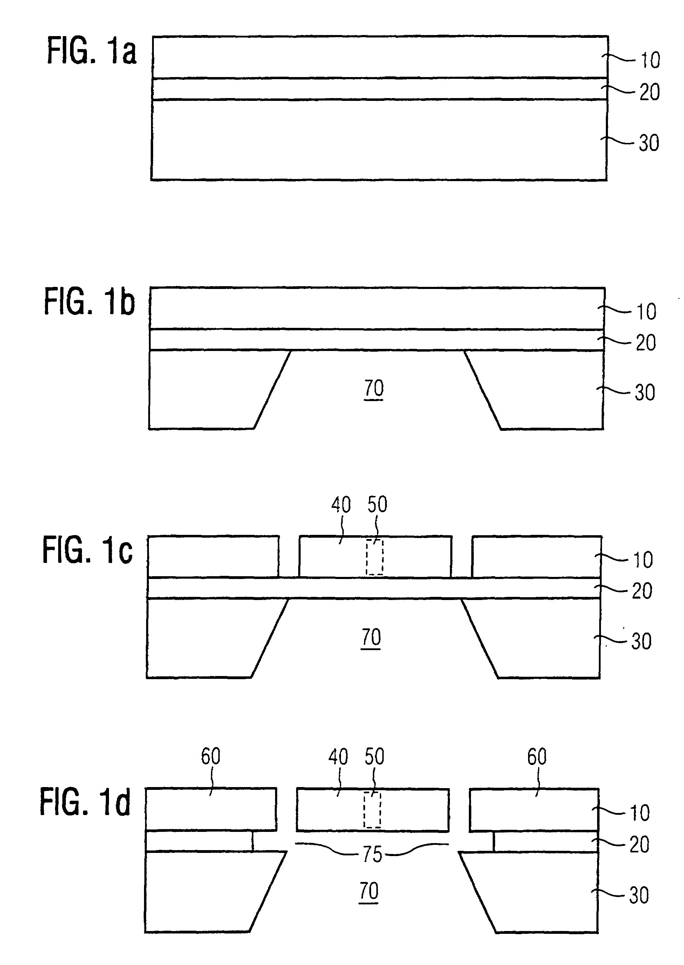

Fig. 1a - 1e zeigen eine Querschnittsdarstellung der Prozeßschritte gemäß einer ersten bevorzugten Ausführungsform des erfindungsgemäßen Verfahrens zur Herstellung eines Schwingspiegels.

In Figur 1a ist eine SOI-Waferstruktur mit einer SOI-Schicht 10, welche unter Zwischensetzen einer Isolationsschicht 20 (z.B. einer Oxidschicht) auf einer Siliziumsubstratschicht 30 vorgesehen ist, dargestellt.

Gemäß Figur 1b wird die Siliziumsubstratschicht 30 bis zur Isolationsschicht 20 durch Naßätzen durchgeätzt. Dies geschieht zweckmäßigerweise mit TMAH, KOH und wird bei einem vorderseitig ätzgeschützen und rückseitig maskierten SOI-Wafer zur Erzeugung eines Kavernenbereiches 70 durchgeführt.

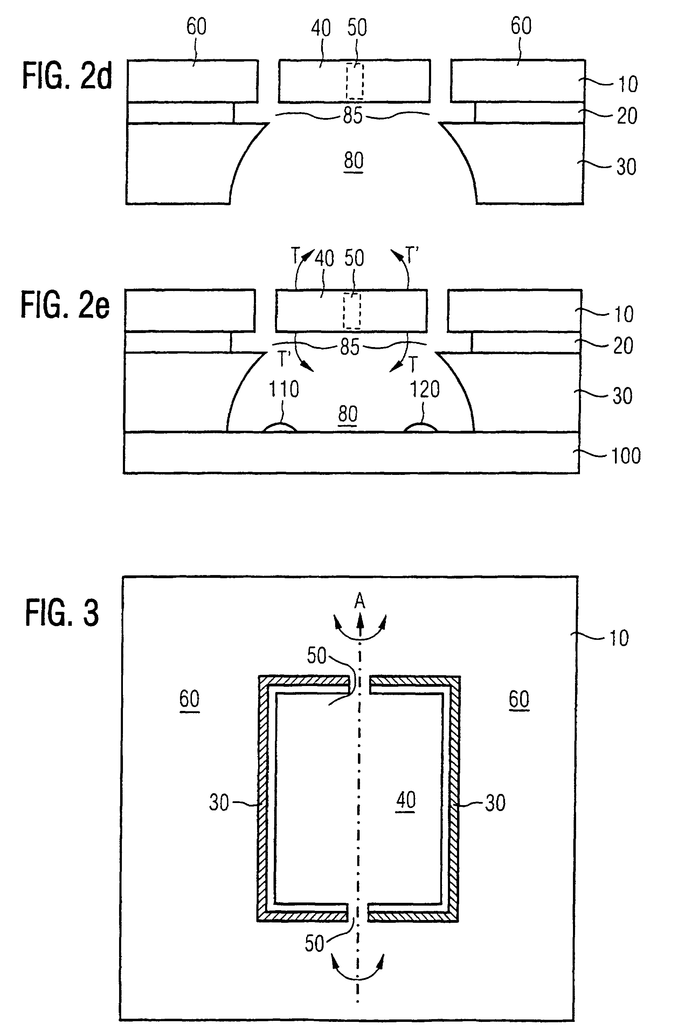

Gemäß Figur 1c erfolgt darauf ein Durchätzen der SOI-Schicht 10 bis zur Isolationsschicht 20 zum Erzeugen eines auf der Isolationsschicht 20 liegenden Inselbereichs 40, der über zwei Verbindungsstege 50 (vergl. Figur 3) mit dem den Inselbereich 40 umgebenden Bereich 60 der SOI-Schicht 10 verbunden ist. Das Ätzen geschieht nach einer Belackung des Rückseiten-Kavernenbereichs 70 mittels eines geeigneten Trockenätzverfahrens, beispielsweise Plasmatrenchen. So wird unter Zurückbelassung von den maskierten Verbindungsstegen 50 die Spiegelstruktur mit Federaufhängungen in das dünne Silizium der SOI-Schicht 10 strukturiert.

Gemäß Figur 1d wird durch das Ätzen der Isolationsschicht 20 in der Gasphase oder durch eine naßchemische Ätzung die Spiegelstruktur freitragend durch die Ausbildung des entfernten Bereichs 75 der Isolierschicht 20.

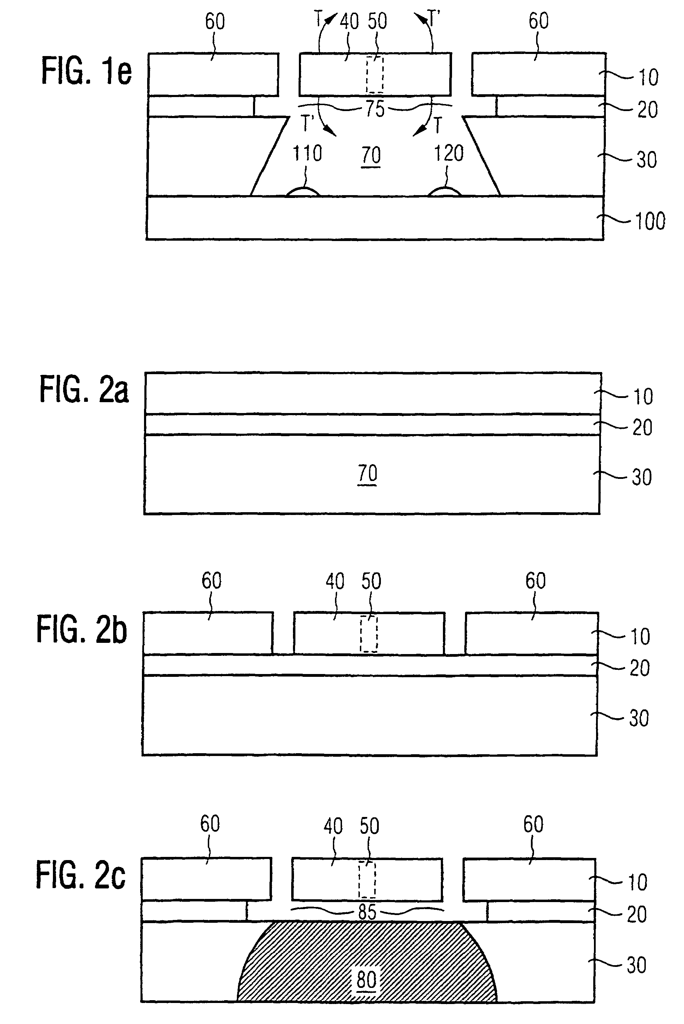

Gemäß Figur 1e werden zum Antrieb des Schwingspiegels geeignete Elektroden 110 und 120 auf der Rückseite auf einem isolierenden Sockel 100 angebracht, und der Sockel 100 wird auf die Siliziumsubstratschicht 30 gebendet oder geklebt. Das leitfähige hochdotierte Silizium des Schwingspiegels wirkt als Gegenelektrode, so daß Torsionsschwingungen in den mit T und T' gekennzeicheten Richtungen möglich sind, die eine solche Amplitude aufweisen, daß ein Teil des Schwingspiegels in den durchgeätzten Bereich 70 der Siliziumsubstratschicht 30 hineinragt.

Fig. 2a - 2e zeigen eine Querschnittsdarstellung der Prozeßschritte gemäß einer zweiten bevorzugten Ausführungsform des erfindungsgemäßen Verfahrens zur Herstellung eines Schwingspiegels.

Figur 2a zeigt die gleiche Darstellung wir Figur 1a, also eine übliche SOI-Struktur.

Im Unterschied zur ersten Ausführungsform wird gemäß Figur 2b zunächst das Ätzen der SOI-Schicht 10 bis zur Isolationsschicht 20 zum Erzeugen des Inselbereichs 40 entsprechend dem Schwingspiegel, der über die beiden Verbindungsstege 50 mit dem den Inselbereich 40 umgebenden Bereich 60 der ersten Schicht verbunden ist, durchgeführt. Dies geschieht wie bei der ersten Ausführungsform mittels eines geeigneten Trockenätzverfahrens mit hoher Lateralauflösung, beispielsweise des Plasmatrenchens.

Gemäß Figur 2c wird eine Anodisierung bei beispielsweise mit Gold entsprechend maskierter Rückseite durchgeführt, wobei eine Endpunkterkennung durch einen Spannungssprung bei vollständiger Anodisierung des zu bildenden Rückseiten-Kavernenbereichs 80 möglich ist. Eine elektrolytische Kontaktierung des hochdotierten Bulks erfolgt auf der Kathodenseite. Gleichzeitig wird das Oxid der Zwischenschicht 20 direkt im Anodisierelektrolyt, beispielsweise Flußsäure, zur Bildung des Bereichs 85 durchgeführt. Durch geeignete Wahl der Anodisierungsparameter kann die Anodisierungsrate sehr viel größer als die Ätzrate der Isolationsschicht 20 aus Oxid eingestellt werden, wodurch nur ein geringes Unterätzen des Umgebungsbereichs der oberen SOI-Schicht 10 stattfindet.

Gemäß Figur 2d erfolgt darauf das Lösen des porösen Siliziums im Bereich 80 durch NH₃, verdünnte KOH oder ähnlichem.

Gemäß Figur 2e werden analog Figur 1e zum Antrieb des Schwingspiegels geeignete Gegenelektroden 110, 120 angebracht. Diese sind isoliert auf dem Sockel 100 vorgesehen, welcher beispielsweise durch Kleben oder durch Bonden, mit der SOI-Struktur verbunden wird.

Fig. 3 ist eine Draufsicht auf den Schwingspiegel im Prozeßstadium von Fig. 1d bzw. Fig. 2d, wobei aus dieser Darstellung die beiden Verbindungsstege 50 als Torsionsfedern deutlich erkennbar sind, welche die Drehachse A für den so gebildeten Schwingspiegel 40 definieren.

Obwohl die vorliegende Erfindung anhand eines bevorzugten Ausführungsbeispiels vorstehend beschrieben wurde, ist sie darauf nicht beschränkt, sondern auf vielfältige Weise modifizierbar.

Beispielsweise können zusätzlich Elektroden auf die der dritten Schicht zugewandten Fläche des Inselbereichs aufgebracht werden.

Auch ist die Erfindung nicht auf eine SOI-Struktur beschränkt, sondern für alle gängigen Materialien mikromechanischer Vorrichtungen anwendbar.

Mit dem erfindungsgemäßen Herstellungsverfahren lassen sich mikromechanische Schwingspiegel für sehr große Amplituden zum Einsatz in Baulasern, Barcode-Lasern, Raumüberwachung, Sitzbelegungserkennung in Kfz o.ä. herstellen.

Schließlich wurde in den obigen Ausführungsbeispielen eine Spiegelstruktur gezeigt, doch ist die Erfindung auch auf Strukturen anwendbar, bei denen der Inselbereich nicht ein Spiegelelement, sondern ein sonstiger mechanischer Aktor, wie z.B. ein Stellglied o.ä. ist.

### BEZUGSZEICHENLISTE:

| | |
|---|---|
| 10 | erste Schicht |
| 20 | zweite Schicht |
| 30 | dritte Schicht |
| 40 | Inselbereich |
| 50 | Verbindungsstege |
| 70, 80 | Rückseiten-Kavernenbereich |
| 75, 85 | entfernter Bereich der zweiten Schicht |
| T, T' | Torsionsschwingungsrichtungen |
| 100 | Sockel |
| 110, 120 | Gegenelektroden |

## Patentansprüche

1. Herstellungsverfahren für eine mikromechanische Vorrichtung, insbesondere für eine mikromechanische Schwingspiegelvorrichtung, mit den Schritten:
Bereitstellen einer dreischichtigen Struktur (10, 20, 30) mit einer ersten Schicht (10), einer zweiten Schicht (20) und einer dritten Schicht (30), wobei die zweite Schicht (20) zwischen der ersten und der dritten Schicht (10, 30) liegt;
Durchätzen der ersten Schicht (10) bis zur zweiten Schicht (20) zum Erzeugen eines auf der zweiten Schicht (20) liegenden Inselbereichs (40), der über einen oder mehrere Verbindungsstege (50) mit dem den Inselbereich (40) umgebenden Bereich (60) der ersten Schicht (10) verbunden ist; und
Durchätzen eines Bereichs (70, 80) der dritten Schicht (30) bis zur zweiten Schicht (20) und Entfernen eines Bereichs (75, 85) der zweiten Schicht (20) unter dem Inselbereich (40) derart, daß der Inselbereich (40) um den einen oder die mehreren Verbindungsstege (50) Bewegungen, vorzugsweise Torsionsschwingungen, ausführen kann, die eine solche Amplitude aufweisen, daß ein Teil des Inselbereichs (40) in den durchgeätzten Bereich (70, 80) der dritten Schicht (30) hineinragt.

2. Verfahren nach Anspruch 1, **dadurch gekennzeichnet, daß** zunächst das Durchätzen des Bereichs (70) der dritten Schicht (30), danach das Durchätzen der ersten Schicht (10) und danach das Entfernen des Bereichs (75) der zweiten Schicht (20) durchgeführt wird.

3. Verfahren nach Anspruch 2, **dadurch gekennzeichnet, daß** das Durchätzen des Bereichs (70) der dritten Schicht (30) durch eine anisotrope Rückseitenätzung durchgeführt wird.

4. Verfahren nach Anspruch 1, 2 oder 3, **dadurch gekennzeichnet, daß** das Durchätzen der ersten Schicht (10) durch eine Trockenätzung durchgeführt wird.

5. Verfahren nach Anspruch 1, **dadurch gekennzeichnet, daß** zunächst das Durchätzen der ersten Schicht (10) und danach das Entfernen des Bereichs (85) der zweiten Schicht (20) und das Durchätzen des Bereichs (80) der dritten Schicht (30) durchgeführt wird.

6. Verfahren nach Anspruch 5, **dadurch gekennzeichnet, daß** das Durchätzen des Bereichs (80) der dritten Schicht (30) durch eine anodische Rückseitenätzung zum Porösmachen des Bereichs (80) der dritten Schicht (30) und anschließendes Entfernen des porös gemachten Bereichs (80) durchgeführt wird.

7. Verfahren nach Anspruch 6, **dadurch gekennzeichnet, daß** der Bereich (85) der zweiten Schicht (20) direkt im Anodisierelektrolyt entfernt wird.

8. Verfahren nach einem der vorhergehenden Ansprüche, **dadurch gekennzeichnet, daß** eine Weiterbildung durch Schritte des Aufbringens von Gegenelektroden (110, 120) auf einem Sockel (100) und Bonden des Sockels (100) auf die dritte Schicht (30) derart erfolgt, daß die Gegenelektroden (110, 120) im wesentlichen gegenüber dem Inselbereich (40) liegen.

9. Verfahren nach einem der vorhergehenden Ansprüche, **dadurch gekennzeichnet, daß** durch den Schritt des Bereitstellens einer SOI-Struktur mit einer SOI-Schicht (10), welche unter Zwischensetzen einer Isolationsschicht (20) auf einer Siliziumsubstratschicht (30) vorgesehen ist, die dreischichtige Struktur (10, 20, 30) bereitgestellt wird.

10. Verfahren nach einem der vorhergehenden Ansprüche, **dadurch gekennzeichnet, daß** als Verbindungsstege (50) schmale stehengelassene Bereiche der ersten Schicht (10) verwendet werden.

11. Verfahren nach einem der vorhergehenden Ansprüche, **dadurch gekennzeichnet, daß** als Verbindungsstege (50) schmale Bereiche einer vorzugsweise metallischen Zusatzschicht verwendet werden.

## Claims

1. Method for producing a micromechanical device, in particular a micromechanical oscillating mirror device, comprising the steps of:
providing a three-layer structure (10, 20, 30) having a first layer (10), a second layer (20) and a third layer (30), with the second layer (20) located between the first and third layers (10, 30);
etching through the first layer (10) to reach the second layer (20) in order to produce an island region (40) which lies on the second layer (20) and is connected via one or more connecting webs (50) to the region (60) of the first layer (10) which surrounds the island region (40); and
etching through a region (70, 80) of the third layer (30) to reach the second layer (20) and removing a region (75, 85) of the second layer (20) beneath the island region (40), in such a manner that the island region (40) can execute movements, preferably torsional oscillations, about the one or more connecting webs (50) with an amplitude which is such that part of the island region (40) projects into the etched-through region (70, 80) of the third layer (30).

2. Method according to Claim 1, **characterized in that** the order of the steps is etching through the region (70) of the third layer (30), then etching through the first layer (10) and then removing the region (75) of the second layer (20).

3. Method according to Claim 2, **characterized in that** the region (70) of the third layer (30) is etched through by means of an anisotropic back-surface etch.

4. Method according to Claim 1, 2 or 3, **characterized in that** the first layer (10) is etched through by means of a dry etch.

5. Method according to Claim 1, **characterized in that** the order of the steps is etching through the first layer (10), then removing the region (85) of the second layer (20) and etching through the region (80) of the third layer (30).

6. Method according to Claim 5, **characterized in that** the region (80) of the third layer (30) is etched through by means of an anodic back-surface etch in order to make the region (80) of the third layer (30) porous, followed by removal of the region (80) which has been made porous.

7. Method according to Claim 6, **characterized in that** the region (85) of the second layer (20) is removed directly in the anodizing electrolyte.

8. Method according to one of the preceding claims, **characterized in that** a further development is brought about by steps of applying counterelectrodes (110, 120) to a base (100) and bonding the base (100) to the third layer (30) in such a manner that the counterelectrodes (110, 120) lie substantially opposite the island region (40).

9. Method according to one of the preceding claims, **characterized in that** the three-layer structure (10, 20, 30) is provided by the step of providing an SOI structure having an SOI layer (10) which is formed by the intermediate formation of an insulation layer (20) on a silicon substrate layer (30).

10. Method according to one of the preceding claims, **characterized in that** the connecting webs (50) used are narrow regions of the first layer (10) which have been left in place.

11. Method according to one of the preceding claims, **characterized in that** the connecting webs (50) used are narrow regions of a preferably metallic additional layer.

## Revendications

1. Procédé de fabrication pour un dispositif micromécanique, en particulier pour un dispositif micromécanique à miroir oscillant, comprenant les étapes suivantes :
- préparation d'une structure à trois couches (10, 20, 30) possédant une première couche (10), une deuxième couche (20) et une troisième couche (30), la deuxième couche (20) étant située entre la première couche et la troisième couche (10, 30) ;
- gravure traversante de la première couche (10) jusqu'à la deuxième couche (20) pour produire une région en forme d'île (40) qui repose sur la deuxième couche (20) et qui est reliée par une ou plusieurs languettes de liaison (50) à la région (60) de la première couche (10) qui entoure la région en forme d'île (40) ; et
- gravure traversante d'une région (70, 80) de la troisième couche jusqu'à la deuxième couche (20) et élimination d'une région (75, 85) de la deuxième couche (20) au-dessous de la région en forme d'île (40) de telle manière que la région en forme d'île (40) puisse exécuter autour de la languette de liaison ou des plusieurs languettes de liaison (50) des mouvements, de préférence des oscillations de torsion, qui présentent une amplitude telle qu'une partie de la région en forme d'île (40) pénètre dans la région enlevée (70, 80) de la troisième couche (30).

2. Procédé selon la revendication 1,
**caractérisé en ce qu'**
on exécute d'abord la gravure traversante de la région (70) de la troisième couche (30) puis la gravure traversante de la première couche (10), puis l'élimination de la région (75) de la deuxième couche (20).

3. Procédé selon la revendication 2,
**caractérisé en ce que**
la gravure traversante de la région (70) de la troisième couche (30) est effectuée par une gravure anisotrope par la face arrière.

4. Procédé selon la revendication 1, 2 ou 3,
**caractérisé en ce que**
la gravure traversante de la première couche (10) est effectuée par gravure à sec.

5. Procédé selon la revendication 1,
**caractérisé en ce que**
la gravure traversante de la première couche (10) est effectuée initialement, puis l'élimination de la région (85) de la deuxième couche (20), puis la gravure traversante de la région (80) de la troisième couche (30).

6. Procédé selon la revendication 5,
**caractérisé en ce que**
la gravure traversante de la région (80) de la troisième couche (30) est effectuée par une gravure anodique par la face arrière pour rendre poreuse la région (80) de la troisième couche (30) et par une élimination ultérieure de la région (80) rendue poreuse.

7. Procédé selon la revendication 6,
**caractérisé en ce que**
la région (85) de la deuxième couche (20) est éliminée directement dans l'électrolyte d'anodisation.

8. Procédé selon une des revendications précédentes,
**caractérisé en ce qu'**
un développement est réalisé par des étapes d'application de contre-électrodes (110, 120) sur un socle (100) et par la fixation du socle (100) sur la troisième couche (30) de telle manière que les contre-électrodes (110, 120) se trouvent sensiblement en face de la région en forme d'île (40).

9. Procédé selon une des revendications précédentes,
**caractérisé en ce que**
la structure à trois couches (10, 20, 30) est préparée par l'étape de la préparation d'une structure SOI possédant une couche SOI (10) qui est prévue sur une couche de substrat de silicium (30) avec interposition d'une couche isolante (20).

10. Procédé selon une des revendications précédentes,
**caractérisé en ce que**
d'étroites régions de la première couche (10) qui ont été laissées en place sont utilisées comme languettes de liaison (50).

11. Procédé selon une des revendications précédentes,
**caractérisé en ce que**
d'étroites régions d'une couche additionnelle de préférence métallique sont utilisées comme languettes de liaison (50).
